# EUROPEAN PATENT APPLICATION

(11) **EP 0 742 444 A2**
(43) Date of publication of application: **13.11.1996**
(21) Application number: 96302811.3
(22) Date of filing: 22.04.1996
(51) Int. Cl.: G01R 21/133, G01R 21/00

(54) **Improvements in or relating to electricity meters**

(30) Priority: 06.05.1995 GB 9509280
(71) Applicant: SIEMENS MEASUREMENTS LIMITED, Oldham, Lancashire OL9 7JS (GB)
(72) Inventor: Strumik, Michael, Bardsley, Oldham OL8 2TN (GB); McNutt, Ian, Anderton, Chorley PR6 9HN (GB); Bain, David, Ramsbottom, Bury, Lancashire BL0 9FN (GB)
(74) Representative: Allen, Derek

(57) **Abstract**

A modulised utility meter comprising a basic meter module, which is adapted for fixture in the premises of a consumer, and an 'add-on' module which is adapted to be received by the basic meter module, the modules each including a central processor unit (CPU), which serves to control operation of the module with which it is associated, which CPU includes a store for data appertaining to a quantity of the utility used as measured by meter means in the module of which it forms a part, and a comparator in one module which is arranged to compare the data of respective modules, and to provide an output signal in the absence of predetermined correspondence therebetween.

## Description

This invention relates to modulised utility meters, and more especially it relates to modulised electricity meters.

Such meters are the subject of our co-pending patent application numbers 9424461.3, 9501771.1, 9501772.9, (F21091), (F21092), (F21093), (F21094) and (F21096), to which attention is hereby directed.

Modulised electricity meters comprise a basic meter module with which 'add-on' modules can be operatively associated to extend functionality and for example, a basic credit meter module may be converted to a pre-payment module by the addition of an 'add-on' module arranged to receive pre-payment tokens or the like.

The 'add-on' module may be actually fitted to the basic meter module or it may be positioned remote from (i.e. in a convenient position to receive tokens or smart cards).

Modulised electricity meters have the advantage that basic parts required for metering can be included in the basic meter module, the 'add-on' module being arranged to include those parts necessary for the additional functions required, e.g. a pre-payment function or a radio tele-meter function.

One problem with modulised meters is that they tend to be more vulnerable to fraudulent attempts to obtain supplies of the utility concerned without appropriate payment. For example, it might be possible with modulised meters for a fraudster to obtain (perhaps by theft) an 'add-on' module containing 'credits' for supply of the utility, which 'add-on' module can be fitted to a basic meter module so that the credits can be used.

It is an important object of the present invention to provide a modulised utility meter which is resistant to this kind of fraud.

According to the present invention a modulised utility meter comprises a basic meter module, which is adapted for fixture in the premises of a consumer, and an 'add-on' module which is adapted to be received by the basic meter module, the modules each including a central processor unit (CPU), which serves to control operation of the module with which it is associated, which CPU includes a store for data appertaining to a quantity of the utility used as measured by meter means in the module of which it forms a part, and a comparator in one module which is arranged to compare the data of respective modules, and to provide an output signal in the absence of predetermined correspondence therebetween.

The comparator may be a part of the CPU in the 'add-on' module.

Each module may be arranged to include a further store for data corresponding to an identification number of the module of which it forms a part, one further comparator being provided responsive to respective said further stores for providing a further output signal in the absence of predetermined correspondence between the data stored in each of the said further stores.

The modulised meter may be a modulised electricity meter and the 'add-on' meter module may be a pre-payment meter adapted to receive tokens or the like in pre-payment for electricity to be supplied.

It may be arranged that the said predetermined difference between the data stored in the said stores, is adjustable, an adjustable filter being provided for setting the said predetermined difference.

In order to provide for communication between the modules of the modulised meter, each module may be provided with an optical communication port, operable under control of the CPU in the module in which it is contained, the optical communication ports being positioned and arranged so that communication therebetween is facilitated when the modules are mutually contiguously and operatively associated.

One embodiment of the invention will now be described by way of example only, with reference to the accompanying drawings, in which,

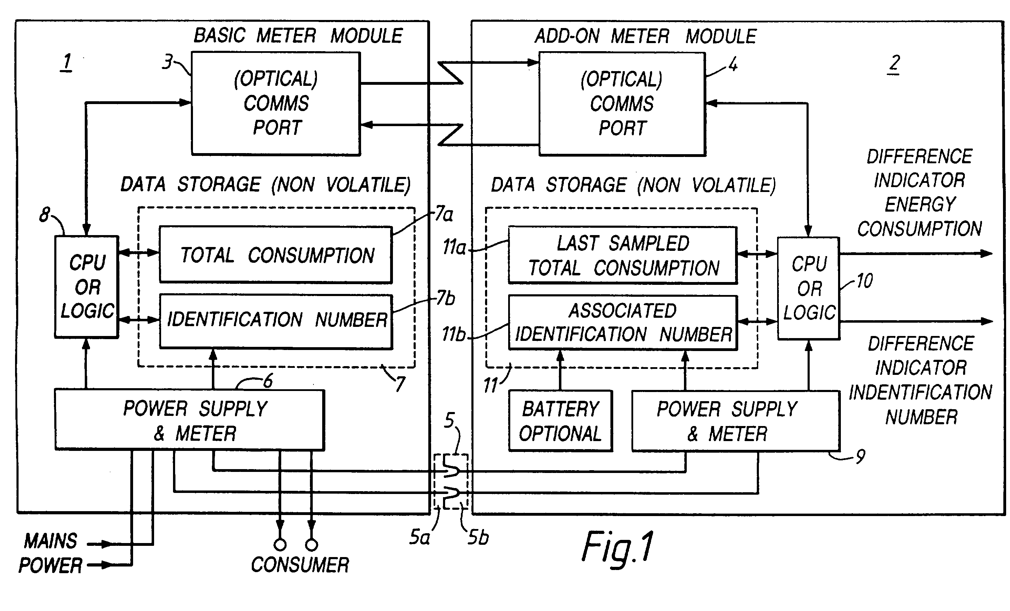

FIGURE 1 is a somewhat schematic circuit block diagram of a modulised electricity meter, comprising a basic meter module, operatively associated with an 'add-on' meter module, and,
FIGURE 2 is a block circuit diagram showing in greater detail a part of the circuit block diagram shown in Figure 1.

Referring now to the drawings, wherein corresponding parts of the two Figures bear, as appropriate, the same numerical designations, a modulised electricity meter comprises a basic meter module 1, adapted contiguously to receive an 'add-on' module 2. The basic meter module 1 is provided with a housing (not shown) which is arranged to facilitate fitment of the module 1 in the premises of a consumer. The 'add-on' module 2, which is provided to extend the functionality of the basic meter module 1, is provided with a housing (not shown) which enables it to be fitted to, and to be arranged to be received in interlocking engagement by the basic meter module 1, so that it is mechanically supported by the basic meter module 1 and suitably coupled to the basic meter module 1, optically and electrically to support required functionality. This coupling comprises optical communication ports 3 and 4 in the modules 1 and 2 respectively, and an electrical plug and socket connector 5 having plug/socket parts 5a, 5b. The optical communication ports 3, 4 and the parts 5a and 5b of the plug and socket connector 5 are arranged to be mutually aligned consequent upon fitment of the 'add-on' module 2 to the basic meter module 1, so that optical communication and electrical coupling is provided.

The basic meter module 1 comprises a meter and power supply unit 6, a store 7 and a central processor unit (CPU) 8, which serves to control operation of the meter and the optical communication port 3. The store 7 includes storage registers 7a and 7b for data relating to the quantity of electricity consumed, as measured by the basic meter module 1, and data relating to a unique identification number appertaining to the basic meter module 1, respectively.

Similarly, the 'add-on' meter module 2 includes a power supply and meter unit 9, a CPU 10 and a store 11, which includes storage registers 11a and 11b, for data appertaining to electricity used, as measured by the 'add-on' meter 2 and an identification number associated with the 'add-on' meter module 2, respectively. In the present example, the 'add-on' meter module 2 is a pre-payment module and accordingly means are provided (not shown) for registering pre-payment credits in accordance with the provision of tokens or the like. Thus, the register lla would normally be provided with a digital display for the quantity of electricity which for the time being is available for use.

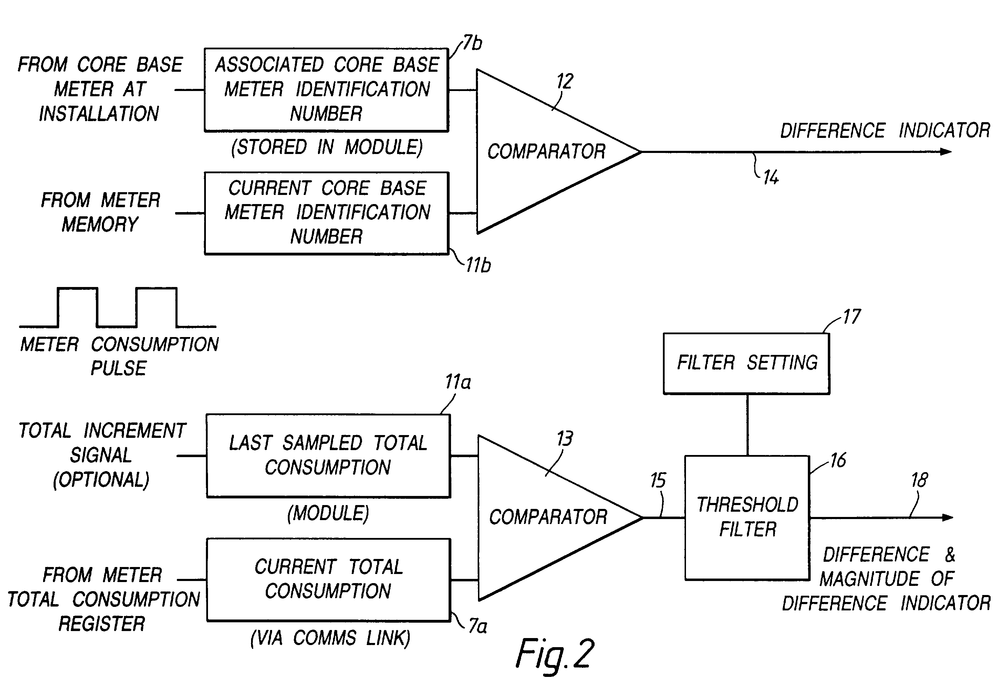

In this embodiment of the invention, two comparators 12 and 13 are included in the CPU 10 of the 'add-on' meter 2 as shown in Figure 2, although in an alternative embodiment they may be included in the CPU 8 of the basic meter module 1. The comparator 12 serves to compare data in the registers 7b and 11b respectively, which relates to the identification numbers of the respective modules 1 and 2, and provides an output signal on a line 14 if an expected relationship between this data does not obtain. For example, the basic meter module 1 and the 'add-on' meter module 2, may have the same identification number which corresponds to the modulised meter assembly of which they both form a part, and if precise correspondence does not obtain between the data as compared by the comparator 12, a predetermined output signal will be provided on the line 14.

The comparator 13 on the other hand, receives data from the registers 11a and 7a, appertaining to the electricity consumption as registered in the 'add-on' module 2 and the basic meter module 1, respectively. If an expected relationship does not obtain between these registers as determined by the comparator 13, an output signal is provided on a line 15.

In order to account for predetermined allowable differences between data in the registers 11a and 7a, a threshold filter 16 is provided, the threshold of which is settable by a filter setting unit 17. In the present example, the threshold filter may simply comprise a threshold level gate, which provides an output signal on a line 18 if a predetermined threshold is exceeded as determined by the setting of the filter setting unit 17 which controls the threshold level.

Thus, it will be appreciated that if the 'add-on' meter module 2 is removed, perhaps by a fraudster, and another 'add-on' meter module is substituted, which may perhaps be stolen, an output signal will be provided on the line 14, since the serial number of the new 'add-on' meter module will not correspond with the expected serial number, and additionally an output signal will be provided on the line 18, since the setting of the register 11a in the substituted 'add-on' module 2 will not correspond with the expected setting.

The signals on the lines 14 and 18 may be used to provide a warning signal, locally or remotely, and additionally the signal on the line 18 may be arranged to reset the register 11a to a true setting as indicated by stored data so that no benefit can be obtained by obtaining a supply without due payment.

Various modifications may be made to the arrangements described without departing from the scope of the invention and for example, the invention may be applied to modulised meters for the supply of other utilities such as gas or water.

## Claims

1. A modulised utility meter comprising a basic meter module, which is adapted for fixture in the premises of a consumer, and an 'add-on' module which is provided to extend functionality of the basic meter module, the modules each including a central processor unit (CPU), which serves to control operation of the module with which it is associated, which CPU includes a store for data appertaining to a quantity of the utility used as measured by meter means in the module of which it forms a part, and a comparator in one module which is arranged to compare the data of respective modules, and to provide an output signal in the absence of predetermined correspondence therebetween.

2. A modulised utility meter as claimed in Claim 1, wherein the comparator is a part of the CPU in the 'add-on' module.

3. A modulised utility meter as claimed in any preceding Claim, wherein each module includes a further store for data corresponding to an identification number of the module of which it forms a part, one further comparator being provided responsive to respective said further stores for providing a further output signal in the absence of predetermined correspondence between the data stored in each of the said further stores.

4. A modulised utility meter as claimed in any preceding Claim, wherein the modulised utility meter is a modulised electricity meter and the 'add-on' meter module is a pre-payment meter adapted to receive tokens or the like in pre-payment for electricity to be supplied.

5. A modulised utility meter as claimed in Claim 4, wherein it is arranged that the said predetermined difference between the data stored in the said stores, in the absence of which the output signal is provided, is arranged to be adjustable.

6. A modulised utility meter as claimed in Claim 5, including an adjustable filter fed from the said comparator by means of which filter the said output signal is arranged to be adjustable.

7. A modulised utility meter as claimed in any preceding Claim, wherein the 'add-on' module is adapted to be received by the basic meter module.

8. A modulised utility meter as claimed in Claim 7, wherein in order to facilitate communication between the modules of the modulised meter, each module is provided with an optical communication port, operable under control of the CPU in the module in which it is positioned, the optical communication ports being positioned and arranged so that communication therebetween is facilitated when the modules are mutually contiguously and operatively associated.
